Europäisches Patentamt

European Patent Office

Office européen des brevets

(11) Veröffentlichungsnummer: **0 418 896 A2**

(12) **EUROPÄISCHE PATENTANMELDUNG**

(21) Anmeldenummer: **90118135.4**

(22) Anmeldetag: **20.09.90**

(51) Int. Cl.5: **H01L 27/02**

(30) Priorität: **22.09.89 DE 3931704**

(43) Veröffentlichungstag der Anmeldung:
**27.03.91 Patentblatt 91/13**

(84) Benannte Vertragsstaaten:
**BE DE FR GB**

(71) Anmelder: **Siemens Aktiengesellschaft**
**Wittelsbacherplatz 2**
**W-8000 München 2(DE)**

(72) Erfinder: **Lachmann, Ulrich, Ing.**
**Zirlerstrasse 11**
**W-8000 München 70(DE)**
Erfinder: **Scherleitner, Armin, Dipl.-Phys.**
**Werinherstrasse 65**
**W-8000 München 90(DE)**
Erfinder: **Zietemann, Heinz, Dipl.-Phys.**
**Adolf-Bayer-Damm 24**
**W-8000 München 83(DE)**

(54) **Schaltungsanordnung zum Schutz elektronischer Schaltungen vor Überspannung.**

(57) Eine in integrierter SBC-Technik mit n-dotierter Buried-Layer-Schicht ausgeführte Schaltungsanordnung mit einer spannungsbegrenzenden Anordnung, insbesondere einer Zenerdiode, und mit vorgeschaltetem Widerstand, bei der die den Widerstand bildende Struktur von einer p-dotierten Buried-Layer-Schicht wannenförmig eingeschlossen ist.

**FIG 2**

EP 0 418 896 A2

## SCHALTUNGSANORDNUNG ZUM SCHUTZ ELEKTRONISCHER SCHALTUNGEN VOR ÜBERSPANNUNG

Die Erfindung betrifft eine Schaltungsanordnung zum Schutz elektronischer Schaltungen vor Überspannung nach dem Oberbegriff des Patentanspruches 1.

Elektronische Schaltungen, insbesondere integrierte Schaltkreise, sind beispielsweise beim Betrieb an Automobilbordnetzen häufig der Gefahr einer Zerstörung durch an den Versorgungsleitungen anliegenden Überspannungen ausgesetzt. Den elektronischen Schaltungen werden deshalb spannungsbegrenzende Anordnungen wie etwa Zenerdiodenvorgeschaltet. Eine verbesserte Anordnung mit Zenerdiode (n) ist beispielsweise aus Robert C. Dobkin, IC Zener Eases Reference Design, National Semiconductor Application Note 173, Nov. 1976, FIG 8, bekannt. Die auf Masse bezogene Spannung einer Versorgungsspannungsquelle wird über einen ersten Widerstand auf den Kollektor eines emitterseitig an Masse liegenden bipolaren Transistors geführt, dessen Basis zum einen über einen zweiten Widerstand mit dem Emitter und über eine Zenerdiode mit dem Kollektor verbunden ist. Die zu schützende Schaltung ist dabei zwischen Masse und den Kollektor des Transistors geschaltet. Durch diese Anordnung wird die zur Versorgung der zu schützenden Schaltung vorgesehene Spannung auf einen Wert begrenzt, der in etwa gleich der über der Zenerdiode abfallenden Spannung ist.

Nachteil der bekannten Anordnung ist der diskrete Aufbau mit einem erhöhten Platz- und Bauteilebedarf. Eine Integration ist jedoch problematisch, da bei einer integrierten Schaltung der mit der Versorgungsspannungsquelle verbundene Anschluß des ersten Widerstandes in Verbindung mit dem Substrat eine auf Masse führende parasitäre Diodenstruktur bildet, welche aufgrund ihrer Durchbruchspannung den zulässigen Eingangsspannungsbereich einschränkt bzw. die Schutzwirkung der gesamten Anordnung bei einem Durchbruch durch parasitäre Ströme stark herabsetzt.

Aufgabe der Erfindung ist es daher, die bekannte Anordnung so abzuwandeln, daß bei integrierter Ausführung ein höherer zulässiger Eingangsspannungsbereich erzielt wird.

Diese Aufgabe wird bei einer gattungsgemäßen Schaltungsanordnung durch die kennzeichnenden Merkmale des Patentanspruches 1 gelöst. Ausgestaltungen des Erfindungsgedankens sind in Unteransprüchen gekennzeichnet.

Vorteil der Erfindung ist es, daß mit geringem schaltungstechnischem Aufwand eine Vervielfachung des Eingangsspannungsbereiches erreicht wird.

Die Erfindung wird nachfolgend anhand des in den FIG in der Zeichnung dargestellten Ausführungsbeispiels näher erläutert. Es zeigt:

FIG 1 das Schaltbild einer Ausführungsform einer erfindungsgemäßen Schaltungsanordnung,

FIG 2 den strukturellen Aufbau einer Ausführungsform einer erfindungsgemäßen Schaltungsanordnung (ausschnittsweise) und

FIG 3 die Strom-Spannungs-Charakteristik einer Ausführungsform einer erfindungsgemäßen Schaltungsanordnung.

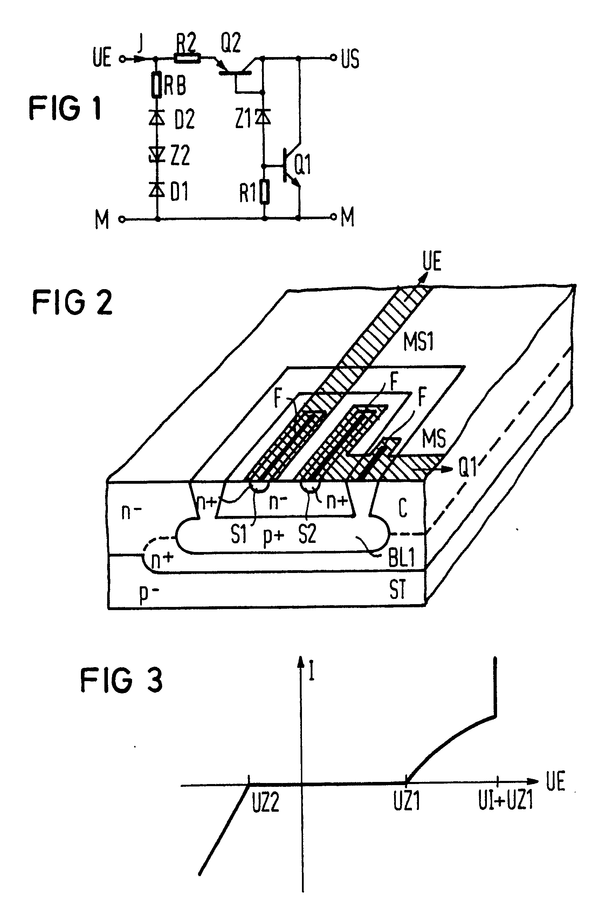

In dem Ausführungsbeispiel gemäß FIG 1 ist die bekannte Anordnung durch einen emitterseitig auf Masse M liegenden ersten Transistor $Q1$, dessen Basis über einen ersten Widerstand $R1$ mit dem Emitter und über eine erste Zenerdiode $Z1$ in Sperrichtung mit dem Kollektor verbunden ist, und durch einen zweiten Widerstand $R2$, über den der Kollektor des ersten Transistors $Q1$ mit einer Eingangsspannung $UE$ beaufschlagt ist, gegeben. Bei einer integrierten Ausführungsform dieser Anordnung bildet der zweite Widerstand $R2$ mit dem Substrat einen pn-Übergang, also eine parasitäre Diode, welche in FIG 1 der Zeichnung als erste Diode $D1$ in Sperrichtung dargestellt ist. In Reihe zu der ersten Diode $D1$ liegt ein Widerstand $RB$, der den in diesem Zweig auf tretenden parasitären Bahnwiderstand symbolisiert. Die Schutzwirkung der bekannten Anordnung wird, wie bereits eingangs erwähnt, aufgrund der Durchbruchspannung der ersten Diode $D1$ begrenzt.

Erfindungsgemäß wird, wie in FIG 2 ausschnittsweise gezeigt, in die in SBC-Technologie (SBC = Standard Buried Collector, vgl. D. Widmann, H. Mader, H. Friedrich, Technologie hochintegrierter Schaltungen, Berlin 1988, S. 292) ausgeführte integrierte Schaltungsanordnung mit $p^-$-dotiertem Substrat ST, mit $n^+$-dotierter Buried-Layer-Schicht $BL1$, mit $n^-$-dotierter Kollektorzone C, so wie mit zwei in Verbindung mit der Kollektorzone C den ersten Widerstand $R1$ aus FIG 1 bildenden $n^+$-dotierten Strukturen $S1$ und $S2$, eine weitere, $p^+$-dotierte Buried-Layer-Schicht $BL2$ derart eingebracht, daß diese in der Umgebung der beiden Strukturen $S1$ und $S2$ die Kollektorzone C in zwei voneinander unabhängige Bereiche aufteilt. Die Buried-Layer-Schicht $BL2$ reicht somit, eine Wanne bildend, an den Randbereichen bis an die Oberfläche. Die Kontaktierung der beiden Strukturen $S1$ und $S2$ sowie der Buried-Layer-Schicht $BL2$ erfolgt über jeweils eine streifenförmige Metallisierungsschicht $MS1$ und $MS2$, wobei die Metallisierungsschichten $MS1$ und $MS2$ auf einer isolierenden Oxidschicht aufgebracht sind und nur an den jeweiligen Strukturen $S1$, $S2$ bzw. an der Buried-Layer-Schicht $BL2$ vorgesehenen Aussparungen F der

Oxidschicht in Kontakt stehen. Dabei verbindet die Metallisierungsschicht MS1 die Struktur S1 mit einem mit der Eingangsspannung UE beaufschlagten Anschluß und die Metallisierungsschicht MS2 die Struktur S2 und die Buried-Layer-Schicht BL2 mit einem in Ausgestaltung der Erfindung dem Widerstand R2 nachgeschalteten, als Diode in Durchlaßrichtung betriebenen Transistor Q2.

Damit erweitert sich die bekannte Anordnung gemäß FIG 1 zum einen um den zwischen Widerstand R2 und dem Kollektor des Transistors Q1 geschalteten Transistor Q2 und zum anderen um eine in Reihe zum Widerstand RB und der Diode D1 liegende zweite Diode D2 in Sperrichtung sowie um eine zweite Zenerdiode Z2 in Durchlaßrichtung. Die begrenzte Eingangsspannung liegt als Spannung US da bei am Kollektor des Transistors Q1 an.

Die Erfindung ausgestaltend ist auch der Transistor Q2 in gleicher Weise wie der zweite Widerstand R2 mit einer $p^+$-dotierten Buried-Layer-Schicht umgeben, und somit auch mit einer höheren Eingangsspannung belastbar.

In FIG 3 der Zeichnung ist der Verlauf des Eingangsstromes E der Anordnung gemäß FIG 1 ohne Last in Abhängigkeit von der Eingangsspannung UE dargestellt. Bei positiver Eingangsspannung UE ist der Eingangsstrom E für Werte kleiner der Zenerspannung UZ1 der ersten Zenerdiode Z1 annähernd gleich Null, für Werte zwischen der Zenerspannung UZ1 und einer Isolationsspannung UI proportional zur Eingangsspannung UE in Abhängigkeit R1 und RB und darüber hinaus steil ansteigend. Für negative Werte der Eingangsspannung UE kleiner als die Zenerspannung UZ2 der zweiten Zenerdiode Z2 ist der Eingangsstrom E annähernd gleich Null und steigt darüber hinaus abhängig vom Bahnwiderstand RB proportional zur Eingangsspannung UE an.

Daraus läßt sich zum einen der Vorteil ableiten, daß der mit der Eingangsspannung UE beaufschlagte Anschluß der Schutzschaltung bis zu einem Wert belastet werden kann, der gleich der Zenerspannung UZ1 und der Isolationsspannung UI ist, weil das Epitaxiegebiet, das den zweiten Widerstand R2 enthält, zweifach vom Substrat ST isoliert ist. Der zulässige Eingangsspannungsbereich erhöht sich somit um die Isolationsspannung UI. Zum anderen ist der Vorteil erkennbar, daß eine Verpolsicherheit durch die zweite Zenerdiode Z2 und dem Transistor Q2 erreicht wird, und daß dabei negative Überspannungsspitzen über die Serienschaltung der ersten Diode D1, der zweiten Diode D2, der zweiten Zenerdiode Z2 und dem Widerstand RB abgeleitet werden. Damit wird auch eine Zerstörung des gegenüber Spannung empfindlichen Transistors Q2 verhindert.

**Ansprüche**

1. Schaltungsanordnung zum Schutz einer elektronischen Schaltung vor Überspannung mit einer spannungsbegrenzenden Anordnung (R1, Q1, Z1), insbesondere mit einer Zenerdiode (Z1), und einem vorgeschalteten Widerstand (R2),
**dadurch gekennzeichnet,** daß die Schaltungsanordnung in integrierter Standard-Buried-Collector-Technik mit n-dotierter Buried-Layer-Schicht ausgeführt ist und daß die den Widerstand (R2) bildende Struktur (S1, S2, C) von einer p-dotierten Buried-Layer-Schicht (BL2) wannenförmig ein geschlossen ist.

2. Schaltungsanordnung nach Anspruch 1,
**gekennzeichnet durch** eine Diode (Q2) in Durchlaßrichtung zwischen Widerstand (R2) und spannungsbegrenzender Anordnung (R1, Q1, Z1) eine Diode (Q2) in Durchlaßrichtung.

3. Schaltungsanordnung nach Anspruch 2,
**dadurch gekennzeichnet,** daß die die Diode (Q2) bildende Struktur ebenfalls von einer p-dotierten Buried-Layer-Schicht wannenförmig eingeschlossen ist.

FIG 1

FIG 2

FIG 3